# EUROPEAN PATENT APPLICATION

(11) **EP 2 579 345 A1**
(43) Date of publication of application: **10.04.2013**
(21) Application number: 11786057.7
(22) Date of filing: 21.05.2011
(51) Int. Cl.: H01L 33/64

(54) **RADIATION HEAT DISSIPATION LED STRUCTURE AND THE MANUFACTURING METHOD THEREOF**

(30) Priority: 28.05.2010 CN 201010185720
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074470
(87) International publication number: WO 2011/147285

(57) **Abstract**

Disclosed are a radiation heat dissipation LED structure and a manufacturing method thereof. The radiation heat dissipation LED structure includes a sapphire substrate, an LED epitaxy layer, a base substrate, a radiation heat dissipation film, and a thermally conductive binding layer provided between the sapphire substrate and the radiation heat dissipation film to bind the sapphire substrate and the base substrate. The radiation heat dissipation film consists of a mixture of metal and nonmetal. The surface of the film has a microscopic structure with crystal, which has high efficiency of heat dissipation and can fast transfer the heat generated by the LED epitaxy layer outwards through the base substrate by thermal radiation. Therefore, the working temperature of the LED epitaxy layer is greatly reduced so as to improve the efficiency of light emitting and the lifetime.

## Description

### BACKGROUND OF THE INVENTION

### 1. Field of the Invention

The present invention generally relates to a radiation heat dissipation LED (light emitting diode) structure and a manufacturing method thereof, and more specifically to a radiation heat dissipation LED structure having a radiation heat dissipation film to enhance the cooling effect through thermal radiation.

### 2. The Prior Arts

Recently, LED has been widely applied to various fields due to the advantage in power saving and carbon reducing, and is also selected as one of the possible light sources to replace the traditional light bulb.

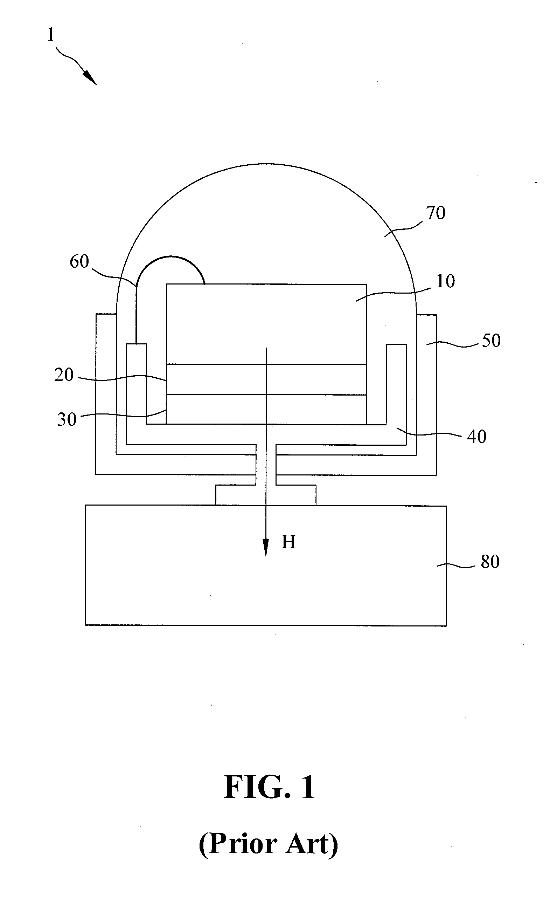

As shown in FIG. 1, the LED structure 1 in the prior arts generally includes an LED chip 10, a sapphire substrate 20, a sliver paste 30, a leadframe 40, a base substrate 50, connection lines 60, a package body 70 and an aluminum heat sink 80. The LED chip 10 is formed on the sapphire substrate 20 and is bound with the leadframe 40 by the sliver paste 30. The base substrate 50 supports the leadframe 40. The connection lines 60 are used to connect the LED chip 10 to the leadframe 40. The leadframe 40 has an extension structure penetrating through the base substrate 50 to contact the aluminum heat sink 80 under the base substrate 50. The heat generated by the LED chip 10 is thus transferred to the aluminum heat sink 80 by thermal conduction, as the heat propagation direction H shown in FIG. 1.

However, one of the shortcomings in the prior arts is that the LED structure 1 may become considerably huge and heavy because the efficiency of heat dissipation depends on the effective surface area for heat dissipation if the heat is transferred primarily by thermal conduction. This may limit the actual application. In addition, the surface area of the aluminum heat sink 80 usually has a huge geometrical shape and the total size of the LED structure 1 is thus further increased such that the LED structure 1 becomes much heavier.

Therefore, it is strongly desired to provide a new radiation heat dissipation LED structure and a method of manufacturing the same improve the efficiency of heat dissipation by thermal radiation without leadframe or aluminum heat sink so as to overcome the above problems in the prior arts.

### SUMMARY OF THE INVENTION

The primary objective of the present invention is to provide a radiation heat dissipation LED structure, which includes a sapphire substrate, an LED epitaxy layer, a base substrate, a radiation heat dissipation film and a thermally conductive binding layer. The LED epitaxy layer is formed on the sapphire substrate. The radiation heat dissipation film is formed on the base substrate, and the thermally conductive binding layer is provided between the sapphire substrate and the radiation heat dissipation film so as to bind the sapphire substrate and the base substrate in order to form the radiation heat dissipation LED structure of the present invention.

The radiation heat dissipation film consists of a mixture of metal and nonmetal and the surface of the film has a microscopic structure with crystal which has a grain size of several nm to several µm. In particular, the radiation heat dissipation film has high efficiency of heat dissipation and can fast transfer the heat generated by the LED epitaxy layer outwards through the base substrate by thermal radiation. Therefore, the working temperature of the LED epitaxy layer is greatly reduced so as to enhance the stability of light emitting and the lifetime. Furthermore, the conducting current in the LED epitaxy layer is allowed to considerably increase such that the efficiency of light emitting is effectively improved. Meanwhile, the leadframe and the aluminum heat sink are no longer needed in the present invention such that the material and manufacturing cost is reduced. Additionally, it is possible to reduce the weight and volume of the radiation heat dissipation LED structure, and hence expand the application scope and improve the convenience in usage.

Another objective of the present invention is to provide a method of manufacturing a radiation heat dissipation LED structure, including the steps of forming the LED epitaxy layer on the sapphire substrate, forming the radiation heat dissipation film on the base substrate, and binding the sapphire substrate and the base substrate by the thermally conductive binding layer so as to form the radiation heat dissipation LED structure.

### BRIEF DESCRIPTION OF THE DRAWINGS

The present invention can be understood in more detail by reading the subsequent detailed description in conjunction with the examples and references made to the accompanying drawings, wherein:

FIG. 1 is a view showing the LED structure in the prior arts;

FIG. 2 is a schematic view showing a radiation heat dissipation LED structure according to one embodiment of the present invention;

FIG. 3 shows a flow diagram of a method of manufacturing the radiation heat dissipation LED structure according to the present invention; and

FIG. 4 is a schematic view showing a radiation heat dissipation LED structure according another embodiment of the present invention.

### DETAILED DESCRIPTION OF THE PREFERRED EMBODIMENT

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

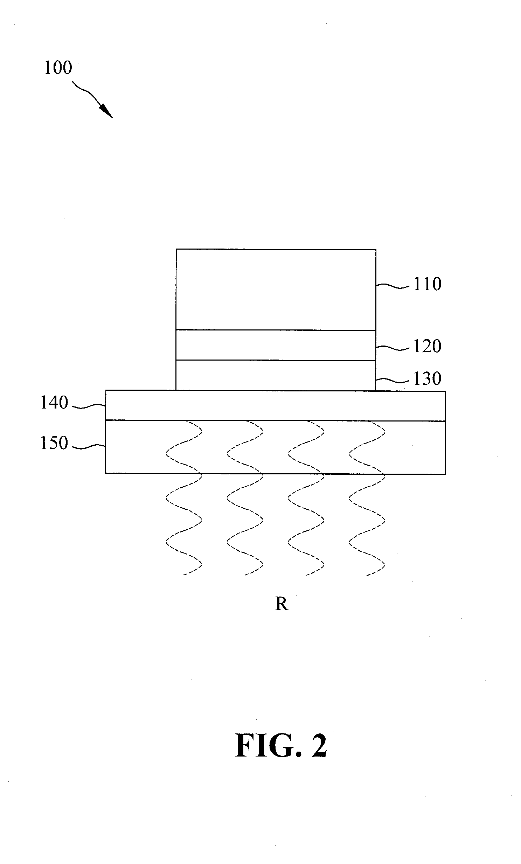

FIG. 2 illustrates the radiation heat dissipation LED structure according to one embodiment of the present invention. As shown in FIG. 2, the radiation heat dissipation LED structure 100 of the present invention includes an LED epitaxy layer 110, a sapphire substrate 120, a thermally conductive binding layer 130, a radiation heat dissipation film 140, a base substrate 150, at least one electrical connection line (not shown) and a package body (not shown). The LED epitaxy layer 110 consists of at least an N type semiconductor layer, a semiconductor light emitting layer and a P type semiconductor layer, which are sequentially stacked. For instance, the N type semiconductor layer is an N type GaN (gallium nitride) layer, the semiconductor light emitting layer may consists of gallium nitride or indium gallium nitride, and the P type semiconductor layer is a P type GaN layer. Further, the P type semiconductor layer and the N type semiconductor layer are respectively connected to a positive end and a negative end of an external power source (not shown) by the at least one electrical connection line. The semiconductor light emitting layer can emit light when the LED epitaxy layer 110 is forward biased (or turned on) due to electron-hole recombination.

The package body consists of silicone or epoxy resin used to enclose the LED epitaxy layer 110 for protection. Meanwhile, the package body may consists of certain amount of appropriate Phosphor powder which can convert part of the original light generated by the LED epitaxy layer 110 into excited light with different wavelength. The excited light is then mixed with the remaining part of the original light to form resulting light. For example, blue light as the original light can be converted and mixed to form white light with a specific color temperature (CT).

The thermally conductive binding layer 130 with high thermal conductivity is provided between the sapphire substrate 120 and the radiation heat dissipation film 140. The thermally conductive binding layer 130 can propagate the heat generated by the LED epitaxy layer 110 through the sapphire substrate 120 towards the radiation heat dissipation film 140. That is, the heat generated by the LED epitaxy layer 110 is transferred to the radiation heat dissipation film 140 through the sapphire substrate 120 and thermally conductive binding layer 130 by thermal conduction. More specifically, the thermally conductive binding layer 130 may consist of silver paste, tin paste, copper-tin alloy or gold-tin alloy.

The radiation heat dissipation film 140 is formed on the base substrate 150 such that the surface of the radiation heat dissipation film 140 in contact with the base substrate 150 has high efficiency of thermal radiation. Therefore, the radiation heat dissipation film 140 can propagate the heat towards the base substrate 150 by the mechanism of thermal radiation R, as shown in FIG. 2.

The radiation heat dissipation film 140 primarily consists of a mixture of metal and nonmetal, which consists of at least one of silver, copper, tin, aluminum, titanium, iron and antimony, and one of oxide, nitride and inorganic acid of at least one of boron and carbon. For instance, the radiation heat dissipation film 140 may consist of halide of titanium antimony. Additionally, the radiation heat dissipation film 140 has a microscopic structure with crystal, which has a grain size between one nanometer and tens of micrometers. It is believed that the crystal formed in the radiation heat dissipation film 140 can induce some specific lattice resonance to strongly emit corresponding thermal radiation, such as infrared or far infrared.

To improve the property of the radiation heat dissipation film 140, the base substrate 150 formed of suitable material is selected. For example, the difference between thermal expansion coefficients of the radiation heat dissipation film 140 and the base substrate 150 is not greater than 0.1%.

In the above-mentioned radiation heat dissipation LED structure 100, the base substrate 150 serves as the heat sink without an additional leadframe or heat sink so as to reduce the manufacturing cost. In particular, the traditional heat sink such as aluminum heat sink is considerably huge and heavy. However, if the aluminum heat sink is used, the aluminum heat sink is possibly higher than the radiation heat dissipation film 140 because of thermal radiation for heat dissipation. Therefore, the radiation heat dissipation LED structure 100 of the present invention can improve the efficiency of heat dissipation for the LED epitaxy layer, simplify the whole LED structure and further reduce the complexity of the design so as to increase the yield. Moreover, the weight and volume are greatly reduced to improve the convenience and expand the application scope.

Additionally, a small heat sink (not shown) can be connected to the base substrate 150 to enhance heat dissipation effect, and the radiation heat dissipation film 140 can propagate the heat to the small heat sink by thermal radiation such that the small heat sink is possibly higher than the LED epitaxy layer 110, which is the only heat source. It is apparent that the mechanism of heat dissipation used in the present invention has a considerable effect different from the traditional scheme. According the actual measurements, the temperature of the radiation heat dissipation film 140 can be up to 125°C when the temperature of the LED epitaxy layer is 115°C.

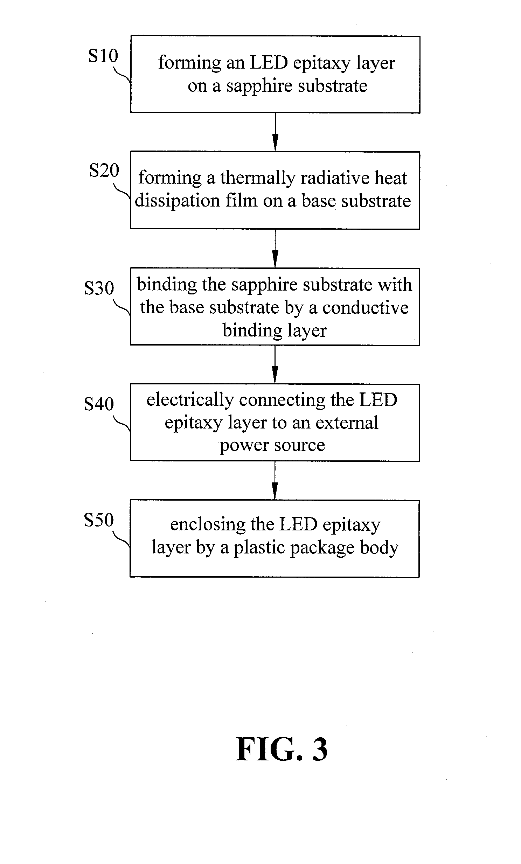

FIG. 3 illustrates the flow diagram of the method of manufacturing a radiation heat dissipation LED structure according to the present invention. As shown in FIG. 3, the method of the present invention includes the steps S10 to S50. First, the method of the present invention begins at the step S10, which is performed to form the LED epitaxy layer on the sapphire substrate. Next, in the step S20, the radiation heat dissipation film is formed on the base substrate. More specifically, a slurry mixture consisting of a solvent and the mixture of metal and nonmetal is sprayed and coated onto the base substrate which is heated such that the solvent evaporates to leave the solid mixture of metal and nonmetal on the base substrate and the radiation heat dissipation film with crystal is formed.

The solvent used in the step S20 may consist of at least one of water, alcohol and ketone, and the mixture of metal and nonmetal is similar to what is described above with respect to FIG. 2. Thus, the detailed description of the mixture of metal and nonmetal is omitted herein for the sake of brevity.

Next, the thermally conductive binding layer is used to bind the sapphire substrate and the radiation heat dissipation film to form the radiation heat dissipation LED structure in the step S30. In the step S40, the electrical connection lines are then used to connect the LED epitaxy layer to the positive and negative ends of the external power source. Finally, the LED epitaxy layer is enclosed by the package body in the step S50. The effect of the package body is described above with respect to FIG. 2.

The method further comprises another step of connecting an additional heat sink to the base substrate to further enhance heat dissipation effect, just like the above-mentioned with respect to FIG. 2.

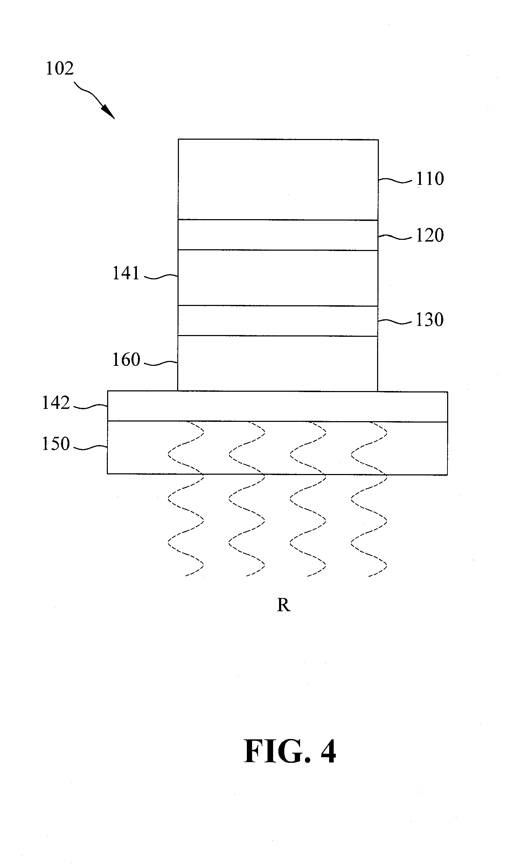

FIG. 4 schematically illustrates another embodiment of the radiation heat dissipation LED structure according to the present invention. As shown in FIG. 4, the radiation heat dissipation LED structure 102 of the present invention includes an LED epitaxy layer 110, a sapphire substrate 120, a first radiation heat dissipation film 141, a thermally conductive binding layer 130, a nano-enamel layer 160, a second radiation heat dissipation film 142, a base substrate 150, at least one electrical connection line (not shown) and a package body (not shown). Specifically, the LED epitaxy layer 110 is formed on the upper surface of the sapphire substrate 120, the first radiation heat dissipation film 141 is formed on the lower surface of the sapphire substrate 120, the second radiation heat dissipation film 142 is formed on the base substrate 150, the nano-enamel layer 160 is formed on the second radiation heat dissipation film 142, and the thermally conductive binding layer 130 is used to bind the first radiation heat dissipation film 141 and the nano-enamel layer 160 to form the radiation heat dissipation LED structure 102.

The first radiation heat dissipation film 141 and the second radiation heat dissipation film 142 are similar to the radiation heat dissipation film 140 as mentioned above. Besides, the LED epitaxy layer 110, the sapphire substrate 120, the thermally conductive binding layer 130, the base substrate 150, the at least one electrical connection line and the package body in this embodiment are also similar to the embodiment in FIG. 2. In particular, the difference between thermal expansion coefficients of the first radiation heat dissipation film 141 and the sapphire substrate 120 is not greater than 0.1 %, and another difference between thermal expansion coefficients of the second radiation heat dissipation film 142 and the base substrate 150 is not greater than 0.1%.

The nano-enamel layer 160 is formed by sintering the nano-particles at high temperature to have a nano-surface. For example, the nano-surface of the ano-enamel layer 160 has a roughness Ra of 10 to 2000. Specifically, the nano-particle is made of aluminum oxide.

Therefore, one aspect of the present invention is that the heat generated by the LED epitaxy layer is primarily propagated in the way of thermal radiation by the first radiation heat dissipation film through the thermally conductive binding layer and the nano-enamel layer towards the second radiation heat dissipation film, and then the second radiation heat dissipation film propagates the heat from the nano-enamel layer towards the base substrate so as to achieve faster and more effective heat dissipation. Therefore, the efficiency of heat dissipation for the whole radiation heat dissipation LED structure is greatly increased.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A radiation heat dissipation LED (light emitting diode) structure, comprising:
a sapphire substrate;
an LED epitaxy layer formed on the sapphire substrate, comprising at least an N type semiconductor layer, a semiconductor light emitting layer and a P type semiconductor layer, which are sequentially stacked, wherein the semiconductor light emitting layer emits light when the LED epitaxy layer is forward biased;
a base substrate;
a radiation heat dissipation film formed on the base substrate;
a thermally conductive binding layer provided between the sapphire substrate and the radiation heat dissipation film to bind the sapphire substrate and the radiation heat dissipation film;
at least one electrical connection line electrically connecting the N type semiconductor layer and the P type semiconductor layer to a positive end and a negative end of an external power source, respectively; and
a package body enclosing the LED epitaxy layer,
wherein the radiation heat dissipation film consists of a mixture of metal and nonmetal, which consists of at least one of silver, copper, tin, aluminum, titanium, iron and antimony, and one of oxide, nitride and inorganic acid of at least one of boron and carbon, and the radiation heat dissipation film has a microscopic structure with crystal.

2. The radiation heat dissipation LED structure as claimed in claim 1, wherein the radiation heat dissipation film contains the crystal with a grain size between one nanometer and tens of micrometers, and a difference between thermal expansion coefficients of the base substrate and the radiation heat dissipation film is not greater than 0.1 %.

3. The radiation heat dissipation LED structure as claimed in claim 1, wherein the base substrate is connected to a heat sink.

4. A manufacturing method of a radiation heat dissipation LED structure, comprising:
forming an LED epitaxy layer on a sapphire substrate, wherein the LED epitaxy layer consists of at least an N type semiconductor layer, a semiconductor light emitting layer and a P type semiconductor layer, and the semiconductor light emitting layer emits light when the LED epitaxy layer is forward biased;
forming a radiation heat dissipation film on a base substrate; and
binding the sapphire substrate and the radiation heat dissipation film by a thermally conductive binding layer to form the radiation heat dissipation LED structure;
wherein the radiation heat dissipation film consists of a mixture of metal and nonmetal, which consists of at least one of silver, copper, tin, aluminum, titanium, iron and antimony, and one of oxide, nitride and inorganic acid of at least one of boron and carbon, and the radiation heat dissipation film has a microscopic structure with crystal.

5. The method as claimed in claim 4, wherein the radiation heat dissipation films contains the crystal with a grain size between one nanometer and tens of micrometers, and a difference between thermal expansion coefficients of the radiation heat dissipation film and the base substrate is not greater than 0.1%.

6. The method as claimed in claim 4, wherein the base substrate is connected to a heat sink.

7. A radiation heat dissipation LED structure, comprising:
a sapphire substrate having an upper surface and a lower surface;
an LED epitaxy layer formed on the upper surface of the sapphire substrate, consisting of at least an N type semiconductor layer, a semiconductor light emitting layer and a P type semiconductor layer, which are sequentially stacked, wherein the semiconductor light emitting layer emits light when the LED epitaxy layer is forward biased;
a first radiation heat dissipation film formed on the lower surface of the sapphire substrate;
a base substrate;
a second radiation heat dissipation film formed on the base substrate;
a nano-enamel layer formed on the second radiation heat dissipation film;
a thermally conductive binding layer provided between the first radiation heat dissipation film and the nano-enamel layer to bind the first radiation heat dissipation film and the nano-enamel layer;
at least one electrical connection line electrically connecting the N type semiconductor layer and the P type semiconductor layer to a positive end and a negative end of an external power source, respectively; and
a package body enclosing the LED epitaxy layer,
wherein each of the first and second radiation heat dissipation films consists of a mixture of metal and nonmetal, which consists of at least one of silver, copper, tin, aluminum, titanium, iron and antimony, and one of oxide, nitride and inorganic acid of at least one of boron and carbon, and each of the first and second radiation heat dissipation films has a microscopic structure with crystal.

8. The radiation heat dissipation LED structure as claimed in claim 7, wherein each of the first and second radiation heat dissipation films contains the crystal with a grain size between one nanometer and tens of micrometers.

9. The radiation heat dissipation LED structure as claimed in claim 7, wherein a difference between thermal expansion coefficients of the first radiation heat dissipation film and the sapphire substrate is not greater than 0.1%, and another difference between thermal expansion coefficients of the second radiation heat dissipation film and the base substrate is not greater than 0.1%.
